Europäisches Patentamt

European Patent Office

Office européen des brevets

(19)

(11) Publication number : **0 483 579 B1**

(12) # EUROPEAN PATENT SPECIFICATION

(45) Date of publication of patent specification :
27.12.95 Bulletin 95/52

(51) Int. Cl.[6] : **G01R 1/067, G01R 31/315, G01B 7/34, G01N 27/00**

(21) Application number : 91117499.3

(22) Date of filing : 14.10.91

(54) Nanometer scale probe for an atomic force microscope, and method for making the same

(30) Priority : 31.10.90 US 608043

(43) Date of publication of application :
06.05.92 Bulletin 92/19

(45) Publication of the grant of the patent :
27.12.95 Bulletin 95/52

(84) Designated Contracting States :
DE FR GB

(56) References cited :
EP-A- 0 437 275
US-A- 4 605 566
JOURNAL OF VACUUM SCIENCE AND
TECHNOLOGY: PART A vol. 8, no. 1, 1 January
1990, NEW YORK US pages 429 - 433 Y.AKA-
MA ET AL 'new scanning tunneling
microscopy tip for measuring surface to-
pography'
PATENT ABSTRACTS OF JAPAN vol. 010, no.
292 (C-376)3 October 1986
APPLIED PHYSICS LETTERS. vol. 56, no. 20,
14 May 1990, NEW YORK US pages 2045 - 2047
A.J.DEN BOEF 'PREPARATION OF MAGNETIC
TIPS FOR A SCANNING FORCE MICROS-
COPE'
IBM TECHNICAL DISCLOSURE BULLETIN.
vol. 32, no. 3B, 1 August 1989, NEW YORK US
pages 310 - 311 'FABRICATION OF CARBON
TIPS FOR AFM/STM PROFILOMETRY'

(56) References cited :
THIN SOLID FILMS. vol. 156, 1988, LAUSANNE
CH pages L31 - L36 G.T.STAUF ; P. A. DOW-
BEN 'PATTERNED PHOTOASSISTED
ORGANOMETALLIC DEPOSITION OF IRON,
NICKEL AND PALLADIUM ON SILICON'
JOURNAL OF VACUUM SCIENCE AND
TECHNOLOGY: PART A vol. 8, no. 4, 1 July
1990, NEW YORK US pages 3386 - 3396 T.R
ALBRECHT ET AL 'MICROFABRICATION OF
CANTILEVER STYLI FOR THE ATOMIC FORCE
MICROSCOPE'

(73) Proprietor : **International Business Machines Corporation**
Old Orchard Road
Armonk, N.Y. 10504 (US)

(72) Inventor : **Clabes, Joachim G.**
420 Cording Road
Yorktown Heights, N.Y. 10598 (US)
Inventor : **Hatzakis, Michael**
12 Hunting Ridge Road
Chappagua, N.Y. 10514 (US)
Inventor : **Lee, Kam L.**
P.O. Box 627
Putnam Valley, N.Y. 10579 (US)
Inventor : **Petek, Bojan**
28 Hollis Lane
Croton-on-Hudson, N.Y. 10520 (US)
Inventor : **Slonczewski, John C.**
161 Allison Road
Katonah, N.Y. 10536 (US)

(74) Representative : **Schäfer, Wolfgang, Dipl.-Ing.**
IBM Deutschland
Informationssysteme GmbH
Patentwesen und Urheberrecht
D-70548 Stuttgart (DE)

EP 0 483 579 B1

## Description

This invention relates to atomic force microscopy, and more particularly, to a nanometer scale probe for use with an atomic force microscope.

Scanned probe microscopy saw its commencement at the atomic level with the invention by Binnig et al. of the scanning tunnelling microscope in the mid-1980's. In the scanning tunnelling microscope (STM), a tiny tungsten probe is maneuvered to within a nanometer above the surface of a conducting specimen, sufficiently close so that there is an overlap between the electron clouds of the atom at the probe tip and of the nearest atom of the specimen. When a small voltage is applied to the tip, electrons "tunnel" across the gap generating a small tunnelling current. The strength of that current is very sensitive to the width of the gap. Piezoelectric controls are used to control the motion of the probe and move it back and forth across the specimen while maintaining a constant gap between its tip and the specimen surface. The variations in voltage applied to maintain the probe properly positioned over the surface are electronically translated into an image of the surface topography.

The invention of STM has led to the development of a family of new scanned-probe microscopes, one of which is the atomic force microscope (AFM) which negates the need for a conducting specimen. In its first implementation, the AFM relied upon the repulsive forces generated by the overlap of the electron cloud at the tip's surface with electron clouds of surface atoms within the specimen. The tip is mounted on a flexible beam which maintains the tip pressed against the specimen surface with constant force as it is moved across the surface.

While a number of methods have been used to measure the movement of the AFM beam/tip, more recently, this is done by a laser beam. The reflected laser is detected and enables beam movements to be converted to imaging signals.

A more recent development is an AFM that is based on the detection of an attractive force between a surface and a probe by its effect on the dynamics of a vibrating probe/beam arrangement. Commonly in such arrangements, a tapered tungsten wire is driven by a piezoelectric transducer mounted at its base to vibrate at close to the wire's resonant frequency. As the tip of the wire is moved across a surface, amplitude changes occur in the vibration as a result of the attractive forces. The changes in the vibration amplitude are sensed by an interferometric laser arrangement.

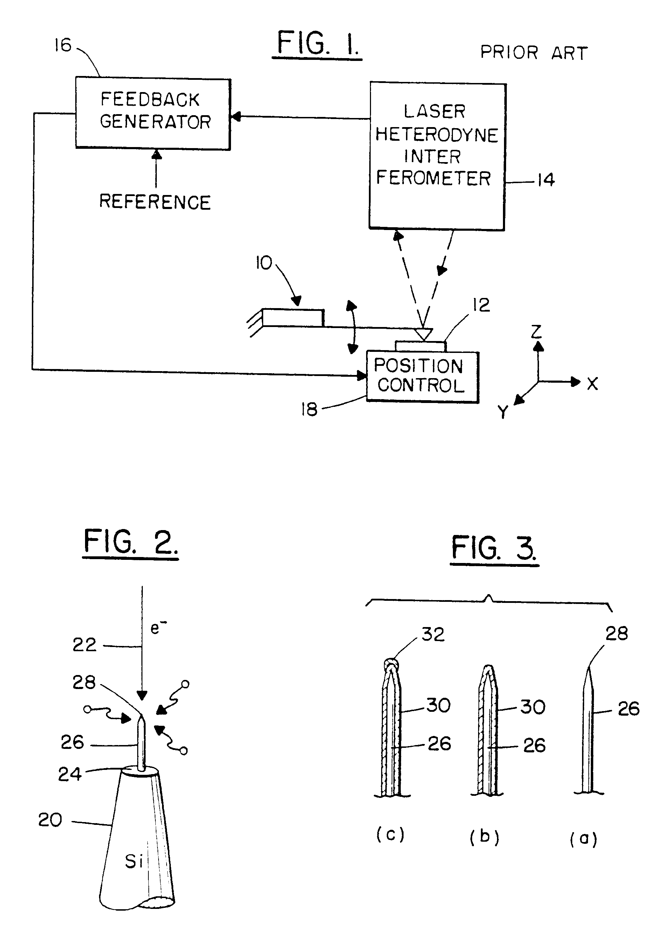

A block diagram of an AFM using interferometric laser detection is shown in Fig. 1, with a probe arrangement 10 being emplaced over the surface of specimen 12. Changes in oscillation amplitude of probe arrangement 10 are sensed by a laser heterodyne interferometer 14 that provides an output signal to a feedback generator 16. As an output signal changes with respect to an applied reference signal, feedback generator 16 provides position control signals to a piezoelectric position control unit 18. Those control signals cause a piezoelectric unit within position control element 18 to move the specimen so that the vibration amplitude is stabilized and, hence the the force gradient. The fluctuations in the feedback potential are converted into a profile of the surface being investigated.

Another variation of the AFM within which the invention can be used is the electrostatic-force microscope where the vibrating probe bears an electric charge and its vibration amplitude is effected by electrostatic forces resulting from charges in the sample. One form of AFM is a magnetic-force microscope (MFM). In an MFM, a magnetized nickel or iron probe is substituted for the tungsten or silicon needles used with other AFM's. When the vibrating probe is brought near a magnetic sample, the tip feels a magnetic force that changes its resonance frequency and hence its vibration amplitude. The MFM traces magnetic-field patterns emanating from the specimen.

The magnetic force components sensed by an MFM probe result from the interaction of the total magnetic dipole moments at the tip of the probe and the specimen. They are further dependent upon the influence of tip-related magnetic fields on the local magnetic moments of the specimen. The lateral resolution of the probe depends critically on the interaction volume constituted by the sample and the tip. For planar magnetic media, this interaction volume is determined primarily by geometric and magnetic properties of the probe tip. Thus, in order to obtain lateral resolutions below 100,0 nm, current tip sizes in the range of 100,0 nm are too large.

Recent theoretical calculations by Wadas in the Journal of Magnetism and Magnetic Materials, Vol. 71, p. 147 (1988) and Vol. 72, p. 292 (1988) show that even for probe tip sizes below 100,0 nm, detection sensitivity of the magnetic forces can be greatly improved by optimization of probe tip shape. Those calculations suggest that only the first 10,0 nm of magnetic material at the tip are effective in contributing to magnetic force interactions that yield high resolution information. The remainder of the magnetic material at the probe tip contributes a background force due to long-range interactions between the magnetic cantilever and the specimen. These interactions are detrimental to sensitivity and spatial resolution and may induce domain wall motion in soft magnetic materials and instability in the tip-to-specimen separation.

Currently, magnetic sensor probe tips are fabricated by an electrochemical etching technique using a ferromagnetic wire material (such as nickel, iron, or cobalt). Essentially the method comprises etching the tip of the wire until it approximates a point. This method does not provide control over the geometric shape of the tip below a 100,0 nm radius. Such probe tips, further, have an unnecessarily large amount of magnetic material with a complicated domain structure. In essence, subtractive processes for creating MFM and other AFM probe tips, do not today, provide the desired atomic-level resolution capability.

The prior art is replete with many additive techniques for deposition of both magnetic and nonmagnetic materials. High energy electron and laser beams are also used to enhance local deposition of materials onto a surface from a gaseous environment. Those systems generally are employed to deposit a pattern onto a substrate, such pattern derived by selective deposition of one or more components of the gaseous environment through which the energy beam is being directed. In U.S. Patent 4,382,186 to Denholm et al., a process is described which employs finely focussed electron beams to effect physical, chemical and other changes on the surface of a substrate. In U.S. Patent 4,670,291 to Mori et al. the injection of exotic atoms into a semiconductor substrate is achieved through the use of an electron beam irradiation scheme.

In U.S. Patent 4,605,566 to Matsui et al., a film is deposited on a semiconductor substrate by passing a gas containing an element over the substrate and then irradiating a determined portion thereof with an electron beam. The gas decomposes and the element is precipitated onto the substrate so as to form a desired pattern. Chromium, molybdenum, aluminum, and tungsten containing organometallics are disclosed. In Japanese Patent 87-295,886/42 the use of organometallic compounds is described for producing a film of VIII metals on a substrate. Electron beams have also been used to enable surface analysis of substrates (e.g., see Kuptsis, IBM Technical Disclosure Bulletin, Vol. 13, No. 9, February 1971, pp. 2497-2498).

More recently, it has been found that iron, nickel, and palladium may be deposited on silicon directly from metallocenes. This is in contrast to other energy-beam assisted deposition systems wherein metal carbonyls and metal alkyls are employed as organometallic source compounds. Such actions are described by Stauf et al. in "Patterned Photo Assisted Organometallic metallic Deposition of Iron, Nickel and Palladium on Silicon", Thin Solid Films, 156 (1988) pp. L31-L36. In specific, Stauf et al. indicate that depositions of metals from the decomposition of cobaltocene, nickelocene, and ferrocene were achieved by both conventional pyrolysis and by single-photon (non-thermal) photodecomposition or plasma-assisted deposition. Photo assisted deposition, as well as electron beam deposition, are essentially non-thermal in character.

In Journal of Vacuum Science and Technology 8(1990) January/February, No. 1, N.Y., pages 429 to 433 electron-beam deposition inside scanning electron microscope (SEM) is used to prepare a new scanning tunneling microscope (STM) tip, an electron-beam deposited (EBD) tip, which has a submicron diameter and a long straight sidewall. An EBD tip as small as less than 0.1 μm in diameter can be formed with careful beam focusing. This EBD tip is formed to be capable of providing a low-distortion STM image of deep grooves, and is quite useful in topographic measurements of microfabricated patterns. In Applied Physics Letters vol. 56, no. 20, 14 May 1990, pages 2045 to 2047 a simple technique for preparing magnetic tips used in a scanning force microscope is described. In this technique a thin layer of ferromagnetic material is deposited on an etched tungsten tip via sputtering or galvanic deposition. Images of magnetic domains obtained with these tips are presented, demonstrating a lateral resolution of the order of 50-100 nm.

Accordingly, it is the object of this invention to disclose a new and advantageous process for producing an AFM probe tip.

According to the present invention as claimed a probe tip for a scanned probe microscope is configured as a needle extending from a surface, the needle further comprising a carbonized matrix of a decomposed organic reactant. The needle exhibits a substantial stiffness along its elongated dimension and has a nanometer scale tip dimension. A method is described for producing such a needle probe tip wherein a substrate is positioned in an evacuated environment; a volatile organic compound is introduced into the environment and an energy beam, for example a laser beam, an electron beam or an x-ray beam from a synchrotron and the like, is directed at the substrate's surface, which energy beam is maintained stably focussed thereon for a preset time period. The beam causes a selective decomposition of the organic compound at the focal point on the substrate surface and causes succeeding layers of decomposition product of the organic compound to grow directly up the beam, to thus produce a substantially rigid nanometer-scale needle-like form. A magnetic layer is then deposited on the top of the structure, such layer having a dimension which restricts the tip to exhibit a single magnetic domain.

For a better understanding of the present invention, together with further objects and advantages, preferred embodiment of the invention are described in the following with reference to the accompanying drawings, in which:

Fig. 1        is a block diagram showing a scanned-probe microscope of the prior art.

Fig. 2        is a schematic, perspective view of a silicon probe on which a nanometer-scale needle probe is grown in accordance with the invention.

Figs. 3(a)-(c)    show three separate versions of the nanometer-scale needle of this invention.

Fig. 4    is a reproduction of a photomicrograph showing a nanometer-scale needle produced on a silicon probe tip in accordance with this invention.

Fig. 5    is a schematic view of a modified scanning electron microscope used to implement the method of this invention.

Referring now to Fig. 2, the structure of an AFM nanometer scale needle probe will be described, including the process for producing such a probe.

Initially, a substrate 20 is placed in an evacuated chamber within an electron beam unit. In this example, substrate 20 is a silicon cone. A volatile, organometallic compound gas stream is then introduced into the subchamber 64, while at the same time, an electron beam 22 is turned on. Beam 22 impinges upon an upper surface 24 of substrate 20 and causes decomposition and preferential deposition of the decomposed products of the organometallic gas onto surface 24. Such deposition occurs within the region irradiated by electron beam 22 and also out therefrom by a radial distance determined by electron scatter from surface 24. If it is assumed that electron beam 22 has a diameter of 6 nanometers, the diameter of the initial deposit is approximately 100 nanometers. As the process continues, additional layers of deposited, decomposed components of the organometallic gas continue to build up, thereby creating a needle-like shape 26.

A conical tip shape for needle 26 and its shank diameter are achieved by control of the primary beam voltage and also the beam's gaussian profile. In general, the needle diameter and the respective cone apex angle decrease with increasing beam voltage ($\cap$10% for a 10 kV increase). Such a needle shape is shown in Fig. 3(a). It has also been found, with appropriate controls, that the apparent diameter of pointed end 28 of needle 26 can be made approximately 10 nanometers. When needle 26 is constructed to exhibit magnetic characteristics, a 10 nanometer tip diameter will restrict the magnetic action thereat to a single domain, thereby avoiding the aforestated problems which arise from long range magnetic field line intercouplings.

The process employed to deposit needle probe 26 onto a substrate is an electron beam chemical vapor deposition (CVD) process. Such processes, per se, are known in the prior art, e.g., see Japanese Patent 87-295,886/42. Nevertheless, to Applicants' knowledge, such processes have not heretofore been employed to produce nanometer scale, needle-like structures having a high aspect ratio. It has further been found that the E-beam CVD process produces a needle probe which exhibits substantial stiffness along its elongated dimension. It is believed that this rigidity results from the CVD process producing a needle with a carbon matrix structure in which metal particles are dispersed. In other words, the included carbon toughens the structure and makes it usable as an AFM probe. Without such structural stiffness, needle probe 26 would be useless as an AFM probe.

While metal carbonyls or metal alkyls can be employed as organometallic source compounds for the CVD process, it is preferred that metallocenes be employed due to the non-thermal, decomposition process occuring under e-beam irradiation. To produce a needle probe having intrinsic magnetic characteristics, cobaltocene, nickelocene, and/or ferrocene are preferred. In such case, a needle structure such as shown in Fig. 3(a) is grown and exhibits intrinsic, but weak, magnetic capabilities. Such needle structure comprises a carbon matrix with nickel, cobalt or iron particles, as the case may be, dispersed therein.

For applications requiring a more strongly magnetic tip on the needle probe, different growth conditions should be employed involving at least two processing steps: a seeding step followed by a plate-up of a magnetic material. Among various alternative methods, two are preferred. In the first method a seeding material (e.g., allycyclopentadienylpalladium) is used to grow needle 26 (see Fig. 3(b)). This results in a non-magnetic needle structure having palladium seed particles interspersed. The entire surface of needle 26 is then covered, in a subsequent electroless plating process, by a magnetic metal layer 30.

In the second method (see Fig. 3(c)) the needle 26 is grown without an included metal component. Then a seeding material 32 is deposited only on the apex of needle 26. This is accomplished by introduction of a gaseous metallorganic containing the seed metal, followed by electron beam exposure of the tip area. A subsequent plating (e.g. selective CVD in a gaseous or liquid environment) of a magnetic metal 30 will therefore be confined to the seeded area at the apex and will yield a single domain magnetic sensor region for needle probe 26.

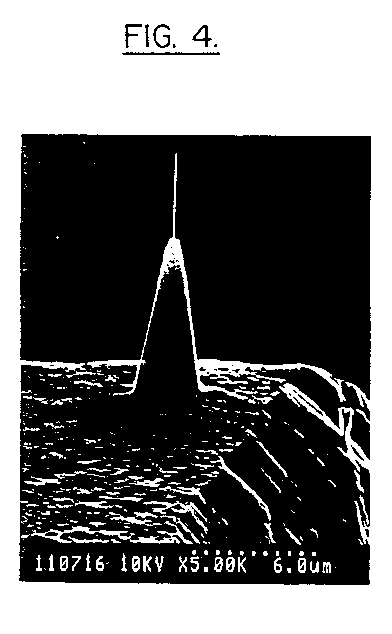

In Fig. 4, a perspective view taken from an SEM photograph is shown wherein a 3 micron long needle probe with a 100 nanometer shank diameter was produced using the method of this invention. The substrate is a silicon pedestal produced via selective etching.

Silicon probe tips such as tip 20 shown in Fig. 2 or the one shown in Fig. 4, are produced by microfabrication techniques that are known in the art. For instance, see Albrecht et al., "Microfabrication of Cantilever Styli for the Atomic Force Microscope", Journal of Vacuum Science Technology, A8(4), July/August 1990, pp. 3386-3396. In that reference and in the references cited therein, techniques are described for selective etching of silicon substrates to enable the creation of an AFM cantilever with an integral pointed silicon probe tip. The procedures used to provide such integral cantilever/probe structures employ selective etching and mask undercutting to enable production of the probe tips. The Albrecht et al. article also describes methods for fabricating thin film $SiO_2$ and $Si_3N_4$ microcantilevers having integral probe tips. Such procedures do not form a part of this invention, although they do provide the methods and procedures whereby an appropriate support surface for the needle probe of this invention can be produced.

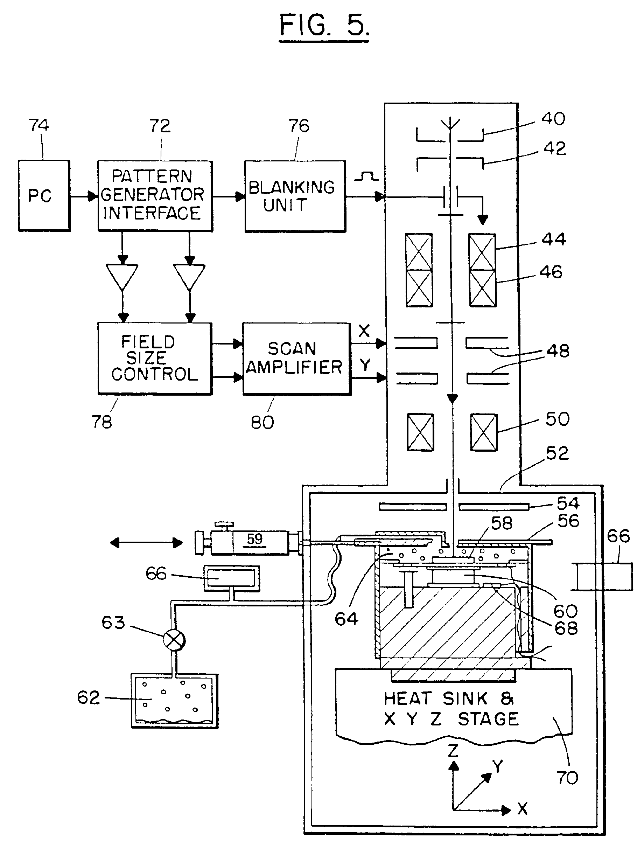

Turning now to Fig. 5, a direct E-beam deposition system is shown and comprises a modified scanning electron microscope. The column portion of the microscope includes a filament 40 which is preferably a lanthanum boride electron source. A movable anode structure 42 is provided to enable the beam brightness to be optimized. The beam passes through a pair of condenser lenses 44, 46, double deflection coils 48 and a final lens 50. From there, the beam enters a lower chamber 52, passes through a backscatter electron detector 54 and then passes into and through a retractable shutter arrangement 56. A linear drive mechanism 59 controls the position of the retractable shutter.

During the period when deposition is occurring, the shutter is closed and the beam passes through a pin hole therein (not shown). When the shutter is open, high resolution secondary electron and scanning transmission imaging can be carried out for probe size monitoring and residual astigmatism correction.

Substrate 58 is positioned in subchamber 64 and on a Peltier effect heater/cooler 60 which maintains constant its temperature. A vapor source 62 provides a vapor of an organometallic containing gas into subchamber 64. A capacitance manometer 66 maintains the pressure within subchamber 64 within desired limits. Various detection systems are included, including a secondary electron detector 66 and a STEM detector 68. The position of substrate 58 is controlled by an XYZ stage 70 and controls that enable the discrete positioning of stage 70 (not shown).

The deposition system is interfaced to a pattern generating unit 72 which is controlled by a personal computer 74 to vector position the electron beam onto the substrate. Electron beam on-time is controlled by an electrostatic blanking unit 76. The exposure time per pixel ranges from 1 microsecond to greater than 100 seconds. For a 50X50 micron field, a beam step size of approximately 5 nanometers can be obtained with 14 bit digital to analog conversion. Such control is exerted by field size control unit 78 through scan control amplifiers 80.

For direct E-beam deposition, a source gas is introduced from vapor source 62 through a metering needle valve 63 into subchamber 64 within lower chamber 52. Subchamber 64 is differentially pumped to an operating pressure range of 10-100 m Torr. Such pressures are compatible with the available beam current densities, and enable optimum growth in the E-beams CVD process. Typical pressure in SEM chamber 52 is approximately $133,3 \cdot 10^{-4} \frac{N}{m^2}$ ($10^{-4}$ Torr) and the pressure in the gun area which encompasses source 40 is approximately $133,3 \cdot 10^{-7} \frac{N}{m^2}$ ($10^{-7}$ Torr).

As the E-beam CVD process is considerably less sensitive than other resist-based processes, relatively long exposure times are required. Such times demand high stability from the electron-optical column and the substrate stage. For the above-noted SEM column, no noticable beam drift was observed and the measured beam current variation over an exposure time of two hours was approximately 5%. The major source of drift was found to occur in the microscope stage where sample cooling caused thermal stresses in the stage assembly. The problem was corrected by providing sufficient heat sinking to subchamber 52. In this manner, sample temperature variation was kept within 1°C, without noticable drift in substrate position.

## EXAMPLE 1

Using the E-beam system shown in Fig. 5, a weak magnetic probe needle comprised of nickel embedded in a carbon matrix, having a shank diameter of approximately 100 nanometers and length of two microns was deposited on a silicon substrate. The organometallic gas used for this example was a nickelocene complex at a vapor pressure of 5 mTorr in subchamber 64. The substrate temperature was 20°C, the beam voltage was 30 kV and the beam size diameter was approximately 6 nanometers. The exposure time was between 5 and 10 minutes.

## EXAMPLE 2

A strong magnetic needle sensor was produced under the following experimental conditions: A needle was first grown under same beam conditions and temperature as described above, using allycyclopentadienylpalladium complex as the vapor source material. Subsequently, the needle surface was plated in an electroless

NiSO$_4$ solution at 65°C yielding ~10nm nickel coverage in 5 seconds.

The above-described E-beam deposition process, when applied to the deposition of a three-dimensional needle-like structure, has the unique characteristic of enabling monolayer film thickness control, high resolution, and the production of a high aspect ratio structure (i.e., more than 31). For most applications, it will probably be advantageous to produce an elongated magnetic tip shape, which would guarantee that the tip be magnetized along its long axis. Given the nanometer scale tip dimension, a single domain probe tip is achieved, enabling imaging of magnetic structures in the sample surface with atomic level resolution.

It should be understood that the foregoing description is only illustrative of the invention. Various alternatives and modifications can be devised by those skilled in the art without departing from the invention. For instance, while it is preferred that an organometallic be used to create the needle-like structure, an organic gas can be employed to grow a carbonized, non-metal needle structure, which is then seeded via deposition of a seed layer, followed by a magnetic metal deposition from a metallocene vapor. Accordingly, the present invention is intended to embrace all such alternatives, modifications and variances which fall within the scope of the appended claims.

## Claims

1. A probe for a scanned-probe microscope, comprising:
   a substrate (20, 58);
   a nanometer scale, needle-shaped structure (26) having an apex (28), exhibiting a high aspect ratio, extending from said substrate, said structure comprising a carbonized material, said structure further exhibiting a substantial stiffness, characterized in that said carbonized material comprises a carbonized matrix of a decomposed organic reactant and that said needle-shaped structure has a single magnetic domain at said apex.

2. The probe as recited in claim 1 wherein said carbonized matrix includes metallic deposits interspersed therein.

3. The probe as recited in claim 2 wherein said metallic deposits exhibit magnetic properties.

4. The probe as recited in claim 3 wherein said structure exhibits a tip diameter sufficiently small that it manifests the single magnetic domain thereat.

5. The probe as recited in claim 1 wherein said substrate comprises a flexible cantilever having an integral protrusion extending in a perpendicular direction therefrom said protrusion having apex surface (24) from which said needle-like structure (26) extends.

6. The probe as recited in claim 5 wherein said flexible cantilever and protrusion are comprised of a silicon-based material.

7. The probe as recited in claim 1 further comprising: a thin metal layer disposed on at least a distal end of said structure, said thin metal layer exhibiting magnetic properties.

8. The probe as recited in claim 7 further comprising:
   a thin metal-containing interlayer disposed between said distal end of said structure and said thin metal magnetic layer.

9. The probe as recited in any of the preceding claims 1 to 8, wherein said needle-shaped structure has an aspect ratio of greater than about 10 to 1.

10. A method for producing a probe for a scanned probe microscope, said probe comprising a substrate (20, 58) and a supported probe tip (28), the method comprising:
    positioning said substrate (20, 58) in an evacuated environment;
    introducing a volatile, gaseous, organic-based compound into said environment, wherein said organic-based compound contains a seeding metal,
    directing an energy beam at said substrate and stably maintaining said beam focused at a point thereon for a set time period, said beam causing decomposition of said organic compound at said point where said beam is incident on said substrate, whereby succeeding layers of decomposition product of said organic-based compound are enable to grow from said substrate in the direction of said beam, to thereby produce a rigid, high aspect ratio, nanometer scale, tip structure;

depositing a metal layer on the surface of said high aspect ratio structure, wherein said metal layer exhibits magnetic properties and has a dimension which restricts said tip to exhibit a single magnetic domain.

11. The method of claim 10 wherein said energy beam is a beam of electrons (22).

12. The method of claim 11, wherein the geometrical details of said tip structure is controlled by beam size and incident beam energy of said beam of electrons.

13. The method of any one of claims 10 to 12, wherein said volatile organic compound is chosen from the class of metallocenes.

**Patentansprüche**

1. Sonde für ein Rastermikroskop, umfassend:
   ein Substrat (20, 58),
   eine nadelförmige Struktur (26) im Nanometerbereich, die eine Spitze (28) besitzt, die ein hohes Aspektverhältnis zeigt und sich von dem Substrat weg erstreckt, wobei die Struktur ein karbonisiertes Material enthält, die Struktur weiter eine beträchtliche Biegefestigkeit aufweist, dadurch gekennzeichnet, daß das karbonisierte Material eine karbonisierte Matrix eines zersetzten organischen Reaktionsteilnehmers umfaßt und daß die nadelförmige Struktur eine einzelne magnetische Domäne an der Spitze aufweist.

2. Sonde nach Anpruch 1, bei der die karbonisierte Matrix metallische Ablagerungen einschließt, die dazwischen eingestreut sind.

3. Sonde nach Anspruch 2, bei der die metallischen Ablagerungen magnetische Eigenschaften zeigen.

4. Sonde nach Anspruch 3, bei der die Struktur einen Spitzendurchmesser aufweist, der genügend klein ist, so daß er die einzelne magnetische Domäne dort offenbart.

5. Sonde nach Anspruch 1, bei der das Substrat einen biegsamen Ausleger aufweist, der einen integralen Vorsprung besitzt, der sich in einer dazu senkrechten Richtung erstreckt, wobei der Vorsprung eine Sockelfläche (24) aufweist, von der aus sich die nadelartige Struktur (26) erstreckt.

6. Sonde nach Anspruch 5, bei der der biegsame Ausleger und der Vorsprung aus einem Material auf Siliziumbasis bestehen.

7. Sonde nach Anspruch 1, weiter umfassend:
   eine dünne Metallschicht, die zumindest auf einem distalen Ende der Struktur angeordnet ist, wobei die dünne Metallschicht magnetische Eigenschaften zeigt.

8. Sonde nach Anspruch 7, weiter umfassend:
   eine dünne metallhaltige Zwischenschicht, die zwischen dem distalen Ende der Struktur und der dünnen metallischen Magnetschicht angeordnet ist.

9. Sonde nach irgendeinem der vorhergehenden Ansprüche 1 bis 8, bei der die nadelförmige Struktur ein Aspektverhältnis von größer als etwa 10 bis 1 aufweist.

10. Verfahren zum Herstellen einer Sonde für ein Rastermikroskop, wobei die Sonde ein Substrat (20, 58) und eine unterstützte Sondenspitze (28) aufweist und das Verfahren umfaßt:
    das Positionieren des Substrates (20, 58) in einer evakuierten Umgebung,
    das Einführen einer flüchtigen, gasförmigen Verbindung auf organischer Basis in die Umgebung, wobei die Verbindung auf organischer Basis ein Keimmetall enthält,
    das Richten eines Energiestrahles auf das Substrat und das stabile Aufrechterhalten des Strahles, der auf einen Punkt darauf fokussiert ist, während eines festgesetzten Zeitraumes, wobei der Strahl das Zersetzen der organischen Verbindung an dem Punkt verursacht, an dem der Strahl auf das Substrat auftrifft, wodurch nachfolgende Schichten des Zersetzungsproduktes der Verbindung auf organischer Basis von dem Substrat aus in der Richtung des Strahles aufwachsen können, um dadurch eine feste Spitzenstruktur im Nanometerbereich mit hohem Aspektverhältnis zu erzeugen,
das Abscheiden einer Metallschicht auf der Oberfläche der Struktur mit hohem Aspektverhältnis, wobei die Metallschicht magnetische Eigenschaften zeigt und eine Abmessung besitzt, die die Spitze begrenzt, um eine einzelne magnetische Domäne zu zeigen.

11. Verfahren nach Anspruch 10, bei dem der Energiestrahl ein Elektronenstrahl (22) ist.

12. Verfahren nach Anspruch 11, bei dem die geometrischen Einzelheiten der Spitzenstruktur durch die Strahlgröße und die Energie des auftreffenden Elektronenstrahles gesteuert werden.

13. Verfahren nach irgendeinem der Ansprüche 10 bis 12, bei dem die flüchtige organische Verbindung aus der Klasse der Metallocene gewählt wird.

## Revendications

1. Sonde pour un microscope à sonde à balayage, comprenant :
un substrat (20, 58),
une structure en forme d'aiguille (26) à échelle nanométrique ayant une pointe (28), présentant un allongement élevé, s'étendant depuis ledit substrat, ladite structure comprenant un matériau carbonisé, ladite structure présentant en outre une rigidité importante, caractérisée en ce que ledit matériau carbonisé comprend une matrice carbonisée de réactif organique décomposé et en ce que ladite structure en forme d'aiguille comporte un domaine magnétique unique sur ladite pointe.

2. Sonde telle que décrite dans la revendication 1 dans laquelle ladite matrice carbonisée comprend des dépôts métalliques dispersés dans celle-ci.

3. Sonde telle que décrite dans la revendication 2 dans laquelle lesdits dépôts métalliques présentent des propriétés magnétiques.

4. Sonde telle que décrite dans la revendication 3 dans laquelle ladite structure présente un diamètre de sommet suffisamment petit pour qu'il puisse manifester sur celui-ci le domaine magnétique unique.

5. Sonde telle que décrite dans la revendication 1 dans laquelle ledit substrat comprend un levier de soutènement flexible comportant une saillie intégrée s'étendant dans une direction perpendiculaire à celui-ci ladite saillie présentant une surface de sommet (24) à partir de laquelle s'étend ladite structure en forme d'aiguille (26).

6. Sonde telle que décrite dans la revendication 5 dans laquelle ledit levier de soutènement flexible et la saillie sont composés de matériau à base de silicium.

7. Sonde telle que décrite dans la revendication 1 comprenant en outre :
une couche métallique fine disposée sur au moins une extrémité distale de ladite structure, ladite couche métallique fine présentant des propriétés magnétiques.

8. Sonde telle que décrite dans la revendication 7 comprenant en outre :
une fine intercouche contenant du métal disposée entre ladite extrémité distale de ladite structure et ladite couche magnétique métallique fine.

9. Sonde telle que décrite dans l'une quelconque des revendications précédentes 1 à 8, dans laquelle ladite structure en forme d'aiguille a un allongement supérieur à environ 10 pour 1.

10. Procédé pour créer une sonde pour un microscope à sonde à balayage, ladite sonde comprenant un substrat (20, 58) et une pointe de sonde supportée (28), le procédé comprenant :
le positionnement dudit substrat (20, 58) dans un environnement de vide,
l'introduction d'un composé à base organique, gazeux, volatil dans ledit environnement, dans lequel ledit composé à base organique contient un métal de germe,
l'action de diriger un faisceau d'énergie sur ledit substrat et à maintenir de façon stable ledit faisceau focalisé en un point de celui-ci pendant un intervalle de temps établi, ledit faisceau amenant la décomposition dudit composé organique audit point où ledit faisceau est incident sur ledit substrat, d'où il résulte que les couches successives de produit de décomposition dudit composé à base organique peuvent croître à partir dudit substrat dans la direction dudit faisceau, afin de produire une structure de pointe à l'échelle nanométrique à allongement élevé, rigide,

le dépôt d'une couche métallique sur la surface de ladite structure à allongement élevé, dans lequel ladite couche métallique présente des propriétés magnétiques et a une dimension qui contraint ladite pointe à présenter un domaine magnétique unique.

11. Procédé selon la revendication 10 dans lequel ledit faisceau d'énergie est un faisceau d'électrons (22).

12. Procédé selon la revendication 11, dans lequel les détails géométriques de ladite structure de pointe sont commandés par la taille du faisceau et l'énergie de faisceau incident dudit faisceau d'électrons.

13. Procédé selon l'une quelconque des revendications 10 à 12, dans lequel ledit composé organique volatil est choisi parmi la classe des alliages organométalliques.

## FIG. 1.

PRIOR ART

16

FEEDBACK
GENERATOR

REFERENCE

LASER
HETERODYNE
INTER
FEROMETER

14

10

12

POSITION
CONTROL

18

Z

X

Y

## FIG. 2.

22

e⁻

28

26

24

20

Si

## FIG. 3.

32

30

26

30

26

28

26

( c )

( b )

( a )

10

# FIG. 4.

110716 10KV X5.00K 6.0um

EP 0 483 579 B1

# FIG. 5.